Europäisches Patentamt

**European Patent Office**

**Office européen des brevets**

(11) Veröffentlichungsnummer: **0 391 125**

**A2**

(12) **EUROPÄISCHE PATENTANMELDUNG**

(21) Anmeldenummer: **90105254.8**

(51) Int. Cl.5: **H03M 1/34**

(22) Anmeldetag: **20.03.90**

(30) Priorität: **05.04.89 DE 3911457**

(43) Veröffentlichungstag der Anmeldung:
**10.10.90 Patentblatt 90/41**

(84) Benannte Vertragsstaaten:
**CH DE FR GB LI SE**

(71) Anmelder: **i f m electronic gmbh
Teichstrasse 4
D-4300 Essen 1(DE)**

(72) Erfinder: **Lamarche, Jean Luc, Dipl.-Ing.
Zeppelinstrasse 1
D-7994 Langenargen(DE)**
Erfinder: **Bürgel, Johannes
Neuhäusle 11
D-7992 Tettnang(DE)**

(74) Vertreter: **Gesthuysen, Hans Dieter, Dipl.-Ing.
Patentanwälte Gesthuysen + von Rohr
Huyssenallee 15 Postfach 10 13 33
D-4300 Essen 1(DE)**

(54) **Verfahren und Schaltungsanordnung zur Umsetzung einer analogen Messspannung in ein digitales Messsignal.**

(57) Dargestellt und beschrieben ist ein Verfahren und eine Schaltungsanordnung zur Umsetzung einer analogen Meßspannung in ein digitales Meßsignal, wobei die Schaltungsanordnung mehrere Komparatoren (3, 4, 5) aufweist und einerseits die Meßspannung und andererseits verschiedene Referenzspannungen an den Eingängen (8, 9, 10, 11, 12, 13) der Komparatoren liegen und die Ausgänge (14, 15, 16) der Komparatoren (3, 4, 5) das Meßsignal führen.

Weniger Aufwand als im Stand der Technik ist dadurch erreicht, daß mit Hilfe des Ausgangssignals des ersten Komparators (3) die Referenzspannung für den zweiten Komparator (4) und mit Hilfe des Ausgangssignals des zweiten Komparators (4) die Referenzspannung für den dritten Komparator (5) steuerbar ist und daß mit Hilfe der Gesamtheit aller Ausgangssignale aller Komparatoren (3, 4, 5) das Meßsignal darstellbar ist.

EP 0 391 125 A2

Fig. 1

Die Erfindung betrifft ein Verfahren und eine Schaltungsanordnung zur Umsetzung einer analogen Meßspannung in ein digitales Meßsignal, - und geht davon aus, daß im Stand der Technik einerseits die Meßspannung und andererseits Referenzspannungen den Eingängen mehrerer Komparatoren zugeführt werden und an den Ausgängen der Komparatoren das Meßsignal abgenommen wird.

Im Stand der Technik werden dann, wenn eine Meßspannung z. B. in ein digitales Meßsignal mit acht diskreten Meßwerten umgesetzt werden soll, acht Komparatoren benötigt; man benötigt also für jeden diskreten Meßwert einen Komparator. Das ist relativ aufwendig, so daß der Erfindung die Aufgabe zugrundeliegt, ein weniger aufwendiges Verfahren bzw. eine weniger aufwendige Schaltungsanordnung zur Umsetzung einer analogen Meßspannung in ein digitales Meßsignal anzugeben.

Das erfindungsgemäße Verfahren, bei dem die zuvor skizzierte Aufgabe gelöst ist, ist zunächst und im wesentlichen dadurch gekennzeichnet, daß die Referenzspannung für den zweiten Komparator abhängig ist vom Ausgangssignal des ersten Komparators, die Referenzspannung für den dritten Komparator abhängig ist vom Ausgangssignal des ersten Komparators und/oder vom Ausgangssignal des zweiten Komparators usw. und daß die Gesamtheit aller Ausgangssignale aller Komparatoren das Meßsignal in codierter Form darstellt. Demgemäß ist die erfindungsgemäße Schaltungsanordnung zunächst und im wesentlichen dadurch gekennzeichnet, daß mit Hilfe des Ausgangssignals des ersten Komparators die Referenzspannung für den zweiten Komparator, mit Hilfe des Ausgangssignals des ersten Komparators udn/oder des Ausgangssignals des zweiten Komparators die Referenzspannung für den dritten Komparator usw. steuerbar ist und daß mit Hilfe der Gesamtheit aller Ausgangssignale aller Komparatoren das Meßsignal darstellbar ist.

Im Stand der Technik werden bei einer z. B. zwischen 0 V und 8 V liegenden Meßspannung, die so in ein digitales Meßsignal umgesetzt werden soll, daß acht diskrete Meßwerte dargestellt werden können, acht Komparatoren benötigt; der Ausgang des ersten Komparators stellt den Wert 0 - 1 V dar, der Ausgang des zweiten Komparators den Wert 1 - 2 V usw., der Ausgang des achten Komparators den Wert 7 - 8 V. Demgegenüber reichen erfindungsgemäß drei Komparatoren aus und wird jeder diskrete Meßwert durch die Gesamtheit aller Ausgangssignale aller Komparatoren dargestellt, nämlich durch ein aus drei bits bestehendes, in codierter Form vorliegendes Meßsignal.

Gegenstand der Erfindung ist, wie eingangs ausgeführt, ein Verfahren und eine Schaltungsanordnung zur Umsetzung einer analogen Meßspannung in ein digitales Meßsignal. Diese Umsetzung muß aber nicht linear erfolgen. Vielmehr Kann zwischen der analogen Meßspannung und dem digitalen Meßsignal jeder gewünschte Zusammenhang hergestellt werden; z. B. kann das zu realisierende digitale Meßsignal logarithmisch oder quadratisch von der umzusetzenden analogen Meßspannung abhängen. Grundsätzlich kann also bei Anwendung des erfindungsgemäßen Verfahrens die Meßspannung in eine der Meßspannung - in der zuvor angedeutete Weise - zugeordnete Hilfsspannung umgesetzt und - erst - die Hilfsspannung den Eingängen der Komparatoren zugeführt werden.

In bezug auf die Abhängigkeit des digitalen Meßsignals von der umzusetzenden analogen Meßspannung ist eine weitere Lehre der Erfindung, der auch losgelöst von der bisher erläuterten Lehre der Erfindung selbständig erfinderische Bedeutung zukommt, dadurch gekennzeichnet, daß die Meßspannung mit einer Schaltreferenzspannung verglichen wird und dann, wenn die Meßspannung die Schaltreferenzspannung erreicht, ein Schaltsignal erzeugt wird, wobei vorzugsweise als Hilfspannung dann, wenn die Meßspannung unterhalb der Schaltreferenzspannung liegt, die Differenz zwischen der Schaltreferenzspannung und der Meßspannung, und dann, wenn die Meßspannung oberhalb der Schaltreferenzspannung liegt, die Differenz zwischen der Meßspannung und der Schaltreferenzspannung gewonnen wird. Die dazu korrespondierende Schaltungsanordnung, der ebenfalls eigenständige erfinderische Bedeutung zukommt, ist dadurch gekennzeichnet, daß eingangsseitig ein Spannungsumsetzer vorgesehen ist und der Spannungsumsetzer die Meßspannung in eine der Meßspannung zugeordnete Hilfsspannung umsetzt, wobei vorzugsweise der Spannungsumsetzer einen Schwellwertschalter aufweist und der Schwellwertschalter dann, wenn die Meßspannung die Schaltreferenzspannung erreicht, ein Schaltsignal erzeugt, wobei weiter vorzugsweise der Spannungsumsetzer einen Differenzverstärker und einen Inverter aufweist und wobei schließlich vorzugsweise der Differenzverstärker und der Inverter dann, wenn die Meßspannung unterhalb der Schaltreferenzspannung liegt, als Hilfsspannung die Differenz zwischen der Schaltreferenzspannung und der Meßspannung, und dann, wenn die Meßspannung oberhalb der Schaltreferenzspannung liegt, als Hilfsspannung die Differenz zwischen der Meßspannung und der Schaltreferenzspannung erzeugt.

Im einzelnen gibt es eine Vielzahl von Möglichkeiten, die Lehre der Erfindung auszugestalten und weiterzubilden. Einerseits wird dazu auf die dem Patentanspruch 1 nachgeordneten Patentansprüche verwiesen. Andererseits dient die Zeichnung dieser Erläuterung, die ein bevorzugtes Ausführungsbeispiel einer erfindungsgemäßen Schaltungsanordnung zum Inhalt hat; in der Zeichnung zeigen

Fig. 1 den Eingangs- und Umsetzerteil des bevorzugten Ausführungsbeispiels einer erfindungsgemäßen Schaltungsanordnung,

Fig. 2 den Komparator- und Anzeigeteil des bevorzugten Ausführungsbeispiels einer erfindungsgemäßen Schaltungsanordnung,

Fig. 3 den Endstufenteil des bevorzugten Ausführungsbeispiels einer erfindungsgemäßen Schaltungsanordnung,

Fig. 4 beispielhaft, den Verlauf einer analogen Meßspannung, die in ein digitales Meßsignal umzusetzen ist, und

Fig. 5 eine grafische Darstellung zur Erläuterung des Eingangs- und Umsetzerteils nach Fig. 1.

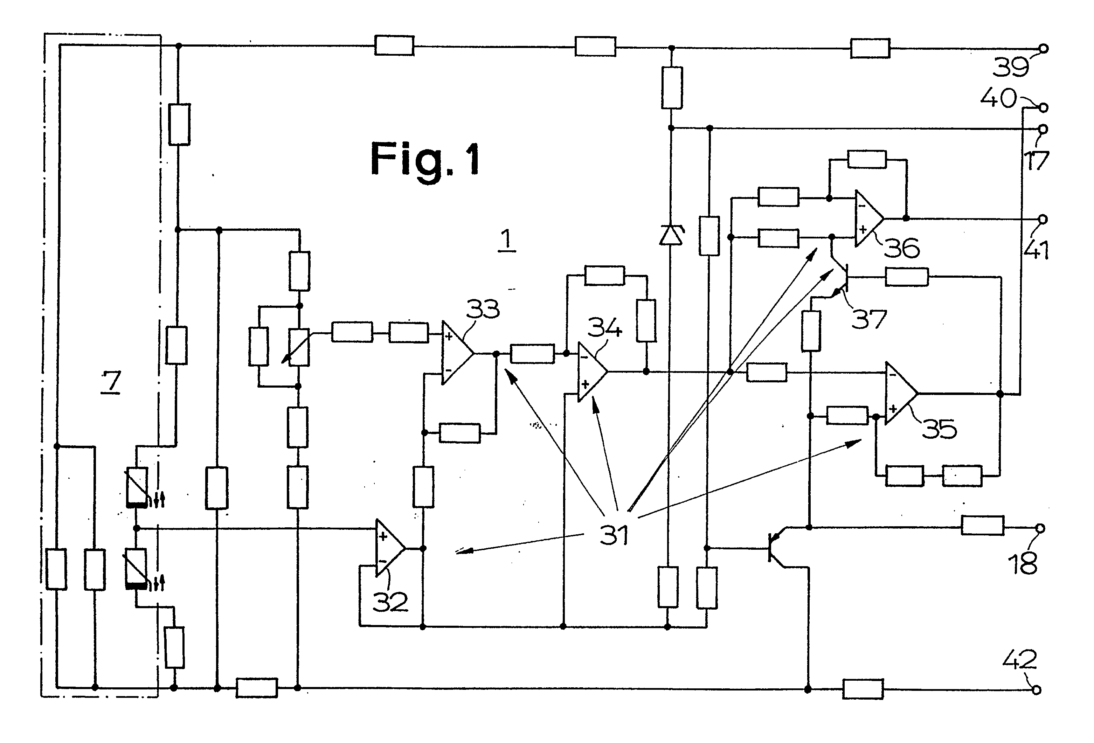

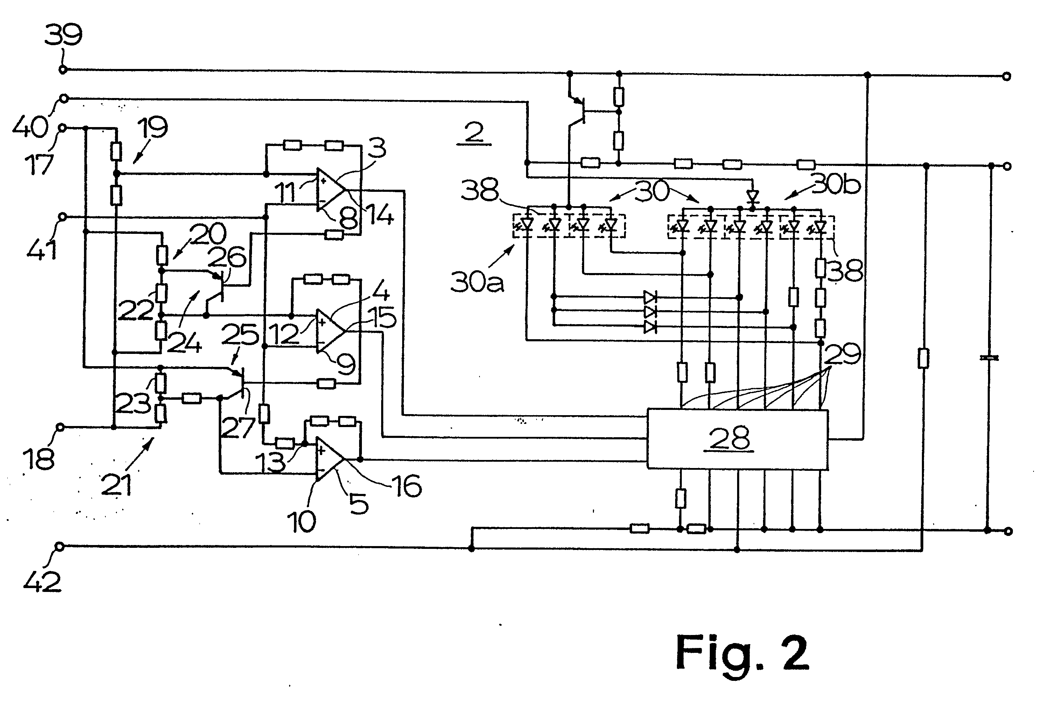

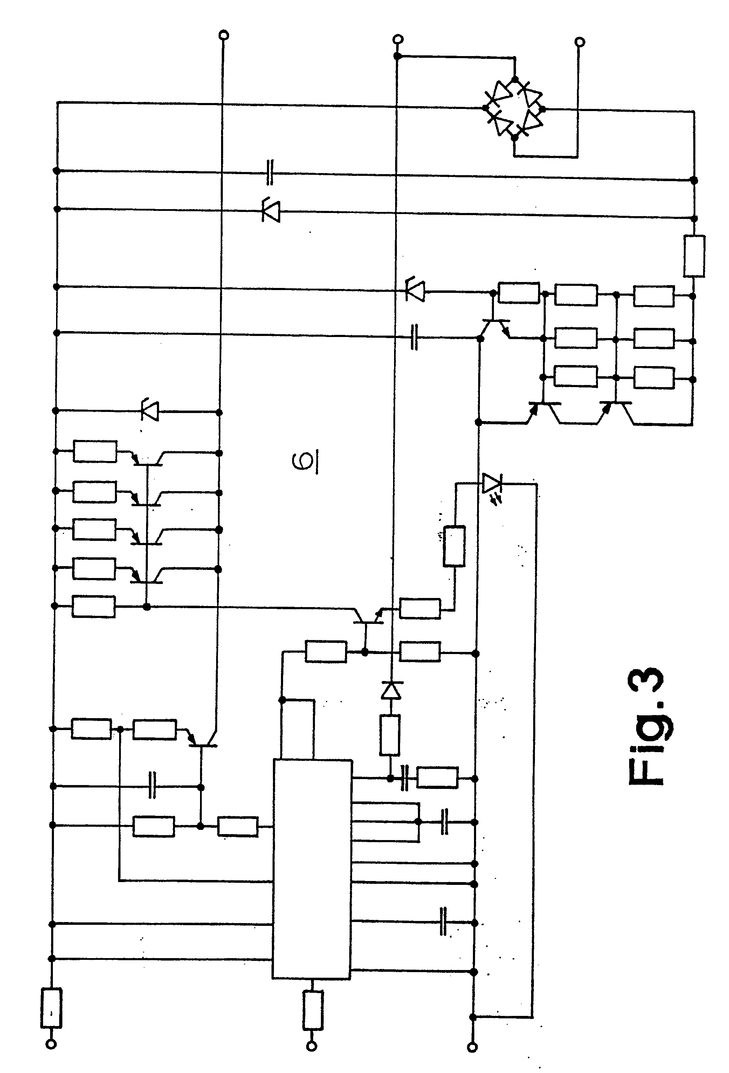

Die in den Figuren dargestellte Schaltungsanordnung dient zur Umsetzung einer analogen Meßspannung in ein digitales Meßsignal und besteht in ihrem grundsätzlichen Aufbau aus einem Eingangs- und Umsetzerteil 1 (Fig. 1), aus einem Komparatorteil 2 (Fig. 2) mit mehreren Komparatoren 3, 4 und 5 und aus einem Endstufenteil 6 (Fig. 3). Im dargestellten Ausführungsbeispiel kommt die analoge Meßspannung, die in ein digitales Meßsignal umzusetzen ist, von einem Sensor 7, z. B. einem Srömungswächter.

Grundsätzlich gilt für die erfindungsgemäße Schaltungsanordnung, daß einerseits die Meßspannung und andererseits verschiedene Referenzspannungen an den Eingängen 8 - 13 der Komparatoren 3 - 5 liegen und die Ausgänge 14, 15, 16 der Komparatoren 3 - 5 das Meßsignal führen.

Erfindungsgemäß ist mit Hilfe des Ausgangssignals des ersten Komparators 3 die Referenzspannung für den zweiten Komparator 4 und mit Hilfe des Ausgangssignals des zweiten Komparators 4 die Referenzspannung für den dritten Komparator 5 steuerbar und ist mit Hilfe der Gesamtheit aller Ausgangssignale aller Komparatoren 3 - 5 das Meßsignal darstellbar.

Im dargestellten Ausführungsbeispiel ist zunächst zur Gewinnung der Referenzspannungen eine Bezugsspannung vorgesehen, und zwar zwischen den Punkten 17 und 18, sind nämlich Spannungsteiler 19, 20, 21 vorgesehen und die Spannungsteiler 19, 20, 21 an die Bezugsspannung angeschlossen. Der Spannungsteiler 20 für die Referenzspannung des zweiten Komparators 4 und der Spannungsteiler 21 für die Referenzspannung des dritten Komparators 5 weisen jeweils einen kurzschließbaren Spannungsteilerwiderstand 22, 23 auf. Den kurzschließbaren Spannungsteilerwiderständen 22, 23 sind Steuertransistoren 24, 25 zugeordnet, deren Basen 26, 27 an den Ausgang 14 des ersten Komparators 3 bzw. an den Ausgang 15 des zweiten Komparators 4 angeschlossen sind. An die Ausgänge 14, 15, 16 der Komparatoren 3, 4, 5 ist ein Analogdemultiplexer 28 angeschlossen. An die Ausgänge 29 des Analogdemultiplexers 28 sind Leuchtdioden 30 angeschlossen.

Für die bisher beschriebene Schaltungsanordnung gilt, daß die Referenzspannung für den zweiten Komparator 4 abhängig ist vom Ausgangssignal des ersten Komparators 3 und die Referenzspannung für den dritten Komparator 5 abhängig ist vom Ausgangssignal des zweiten Komparators 4 und daß die Gesamtheit aller Ausgangssignale aller Komparatoren 3, 4 und 5 das Meßsignal in codierter Form darstellt, daß die Referenzspannungen aus einer Bezugsspannung gewonnen werden, nämlich mit Hilfe der Spannungsteiler 19, 20, 21, daß der Spannungsteiler 20 für die Referenzspannung des zweiten Komparators 4 und der Spannungsteiler 21 für die Referenzspannung des dritten Komparators 5 jeweils einen kurzschließbaren Spannungsteilerwiderstand 22, 23 aufweisen, die kurzschließbaren Spannungsteilerwiderstände 22, 23 mit Hilfe der Steuertransistoren 24, 25 kurzschließbar sind und die Steuertransistoren 24, 25 durch das Ausgangssignal des ersten Komparators 3 und das Ausgangssignal des zweiten Komparators 4 steuerbar sind, daß die Gesamtheit aller Ausgangssignale aller Komparatoren 3, 4 und 5 den Analogdemultiplexer 28 ansteuern und die Ausgänge 29 des Analogdemultiplexers 28 die Leuchtdioden 30 ansteuern.

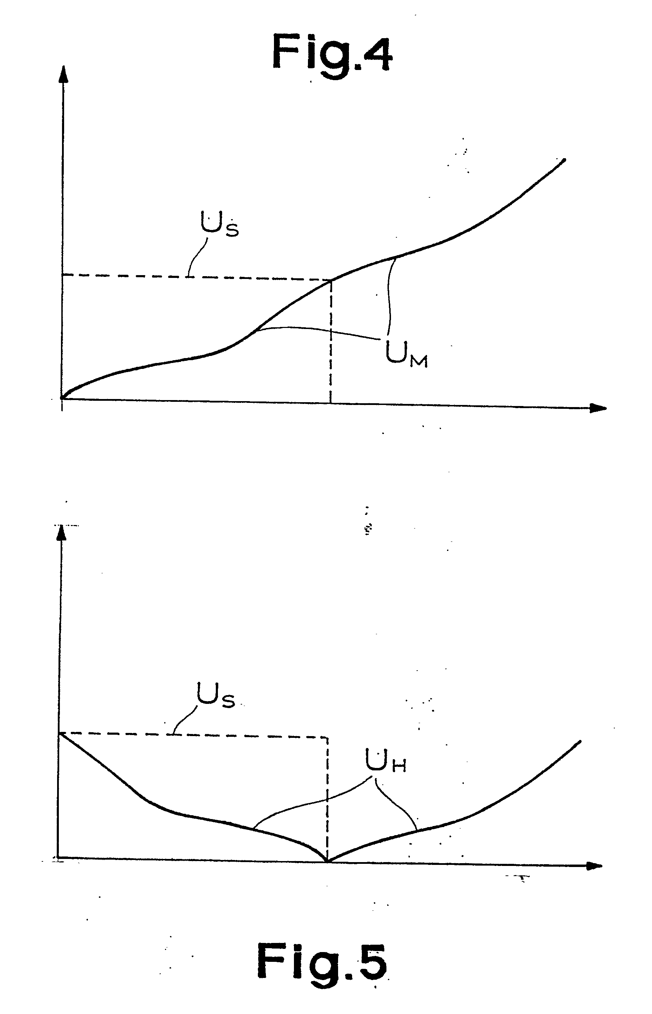

Wie nun die Fig. 1 zeigt, ist im dargestellten Ausführungsbeispiel einer erfindungsgemäßen Schaltungsanordnung eingangsseitig ein Spannungsumsetzer 31 vorgesehen, der die Meßspannung in eine der Meßspannung zugeordnete Hilfsspannung umsetzt; im dargestellten Ausführungsbeispiel wird also nicht die Meßspannung direkt, sondern die der Meßspannung zugeordnete Hilfsspannung den Eingängen 8, 10, 12 der Komparatoren 3, 4, 5 zugeführt. Im einzelnen weist der Spannungsumsetzer 31 einen Impedanzwandler 32, zwei Verstärker 33, 34, einen Schwellwertschalter 35, einen Differenzverstärker 36 und einen Inverter 37 auf. Mit Hilfe des Schwellwertschalters 35 wird die Meßspannung mit einer Schaltreferenzspannung verglichen und wird dann, wenn die Meßspannung die Schaltreferenzspannung erreicht, ein Schaltsignal erzeugt. Der Differenzverstärker 36 und die Inverter 37 erzeugen dann, wenn die Meßspannung unterhalb der Schaltreferenzspannung liegt, als Hilfsspannung die Differenz zwishen der Schaltreferenzspannung und der Meßspannung, und dann, wenn die Meßspannung oberhalb der Schaltreferenzspannung liegt, als Hilfsspannung die Differenz zwischen der Meßspannung und der Schaltreferenzspannung. Das ist in den Fig. 4 und 5 dargestellt, in denen mit $U_M$ die Meßspannung, mit $U_S$ die Schaltreferenzspannung und mit $U_H$ die Hilfsspannung bezeichnet sind.

Wie die Fig. 2 zeigt, sind im dargestellten Ausführungsbeispiel an die Ausgänge 29 des Analogdemultiplexers jeweils Paare von Leuchtdioden angeschlossen, nämlich rote Leuchtdioden 30a und grüne Leuchtdioden 30b. Mit Hilfe des Schwellwertschalters 35 sind entweder die roten Leuchtdioden 30a oder die grünen Leuchtdioden 30b "vorprogrammiert"; in Abhängigkeit davon, welcher Ausgang 29 des Analogdemultiplexers 28 "durchschaltet" und abhängig vom Ausgangssignal des Schwellwertschalters 35 leuchtet also entweder eine rote Leuchtdiode 30a oder eine grüne Leuchtdiode 30b.

Wie bereits ausgeführt, resultiert die analoge Meßspannung $U_M$, die mit Hilfe der erfindungsgemäßen Schaltungsanordnung in ein digitales Meßsignal umgesetzt wird, von dem als Strömungswächter ausgebildeten Sensor 7. Die Meßspannung $U_M$, die der Sensor 7 abgibt, steigt mit zunehmender Strömung; liegt die Strömung unterhalb eines vorgegebenen Sollwertes, so liegt die Meßspannung $U_M$ unterhalb der Schaltungreferenzspannung $U_S$, liegt die Strömung oberhalb des vorgegebenen Sollwertes, so liegt die Meßspannung $U_M$ oberhalb der Schaltreferenzspannung $U_S$. In Abhängigkeit von der Größe der Strömung leuchtet also eine der in Fig. 2 dargestellten Leuchtdioden 30, bei einer unter dem Sollwert liegenden Strömung eine rote Leuchtdiode 30a, bei einer oberhalb des Sollwertes liegenden Strömung eine grüne Leuchtdiode 30b. Die Leuchtdioden 30 geben also - von links nach rechts in Fig. 2 - eine pseudo-analoge Anzeige der Geschwindigkeit der Strömung, die der als Strömungswächter ausgeführte Sensor 7 überwacht.

In Fig. 2 ist angedeutet, daß jeweils ein Paar von roten Leuchtdioden 30a bzw. ein Paar von grünen Leuchtdioden 30b eine gemeinsame Anode haben und in einem gemeinsamen Gehäuse 38 vorgesehen sind, und zwar in einem Gehäuse der Bauform SOT 23. Dieser Lehre kommt auch für sich, losgelöst von den übrigen Lehren der Erfindung, eigenständige erfinderische Bedeutung zu.

Soweit zuvor die in den Fig. 1, 2 und 3 dargestellte erfindungsgemäße Schaltungsanordnung nicht bezüglich aller Bauelemente im einzelnen beschrieben ist, so kommt gleichwohl auch diesen Bauelementen und der den Fig. 1, 2 und 3 ohne weiteres entnehmbaren Schaltung dieser Bauelemente erfinderische Bedeutung zu.

**Ansprüche**

1. Verfahren zur Umsetzung einer analogen Meßspannung in ein digitales Meßsignal, bei dem einerseits die Meßspannung und andererseits verschiedene Referenzspannungen den Eingängen mehrerer Komparatoren zugeführt werden und an den Ausgängen der Komparatoren das Meßsignal abgenommen wird, **dadurch gekennzeichnet,** daß die Referenzspannung für den zweiten Komparator abhängig ist vom Ausgangssignal des ersten Komparators, die Referenzspannung für den dritten Komparator abhängig ist vom Ausgangssignal des ersten Komparators und/oder vom Ausgangssignal des zweiten Komparators usw. und daß die Gesamtheit aller Ausgangssignale aller Komparatoren das Meßsignal in codierter Form darstellt.

2. Verfahren nach Anspruch 1, dadurch gekennzeichnet, daß die Referenzspannungen aus einer Bezugsspannung gewonnen werden.

3. Verfahren nach Anspruch 2, dadurch gekennzeichnet, daß die Referenzspannungen mit Hilfe von Spannungsteilern aus der Bezugsspannung gewonnen werden.

4. Verfahren nach Anspruch 3, dadurch gekennzeichnet, daß der Spannungsteiler für die Referenzspannung des zweiten Komparators und der Spannungsteiler für die Referenzspannung des dritten Komparators jeweils einen kurzschließbaren Spannungsteilerwiderstand aufweisen, die kurzschließbaren Spannungsteilerwiderstände mit Hilfe von Steuertransistoren kurzschließbar sind und die Steuertransistoren durch das Ausgangssignal des ersten Komparators und/oder durch das Ausgangssignal des zweiten Komparators steuerbar sind.

5. Verfahren nach einem der Ansprüche 1 bis 4, dadurch gekennzeichnet, daß die Gesamtheit aller Ausgangssignale aller Komparatoren einen Analogdemultiplexer ansteuern.

6. Verfahren nach Anspruch 5, dadurch gekennzeichnet, daß die Ausgänge des Analogdemultiplexers jeweils mindestens eine Leuchtdiode ansteuern.

7. Verfahren nach einem der Ansprüche 1 bis 6, dadurch gekennzeichnet, daß die Meßspannung in eine der Meßspannung zugeordnete Hilfsspannung umgesetzt und die Hilfsspannung den Eingängen der Komparatoren zugeführt wird.

8. Verfahren nach einem der Ansprüche 1 bis 7, dadurch gekennzeichnet, daß die Meßspannung mit einer Schaltreferenzspannung verglichen wird und dann, wenn die Meßspannung die Schaltreferenzspannung erreicht, ein Schaltsignal erzeugt wird.

9. Verfahren nach Anspruch 7 und 8, dadurch gekennzeichnet, daß als Hilfsspannung dann, wenn die Meßspannung unterhalb der Schaltreferenzspannung liegt, die Differenz zwischen der Schaltreferenzspannung und der Meßspannung, und dann, wenn die Meßspannung oberhalb der Schaltreferenzspannung liegt, die Differenz zwischen der Meßspannung und der Schaltreferenzspannung gewonnen wird.

10. Schaltungsanordnung zur Umsetzung einer analogen Meßspannung in ein digitales Meßsignal, mit mehreren Komparatoren, wobei einerseits die Meßspannung und andererseits verschiedene Referenzspannungen an den Eingängen der Komparatoren liegen und die Ausgänge der Komparatoren das Meßsignal führen, **dadurch gekennzeichnet,** daß mit Hilfe des Ausgangssignals des ersten Komparators (3) die Referenzspannung für den zweiten Komparator (4) mit Hilfe des Ausgangssignals des ersten Komparators und/oder des Ausgangssignals des zweiten Komparators (4) die Referenzspannung für den dritten Komparator (5) usw. steuerbar ist und daß mit Hilfe der Gesamtheit aller Ausgangssignale aller Komparatoren (3, 4, 5) das Meßsignal darstellbar ist.

11. Schaltungsanordnung nach Anspruch 10, dadurch gekennzeichnet, daß zur Gewinnung der Referenzspannungen eine Bezugsspannung vorgesehen ist.

12. Schaltungsanordnung nach Anspruch 11, dadurch gekennzeichnet, daß zur Gewinnung der Referenzspannungen Spannungsteiler (19, 20, 21) vorgesehen und die Spannungsteiler (19, 20, 21) an die Bezugsspannung angeschlossen sind.

13. Schaltungsanordnung nach Anspruch 12, dadurch gekennzeichnet, daß der Spannungsteiler (20) für die Referenzspannung des zweiten Komparators (4) und der Spannungsteiler (21) für die Referenzspannung des dritten Komparators (5) jeweils einen kurzschließbaren Spannungsteilerwiderstand (22, 23) aufweisen, daß den kurzschließbaren Spannungsteilerwiderständen (22, 23) Steuertransistoren (24, 25) zugeordnet sind und daß die Basen (26, 27) der Steuertransistoren (24, 25) an den Ausgang (14) der ersten Komparators (3) bzw. an den Ausgang (15) des zweiten Komparators (4) angeschlossen sind.

14. Schaltungsanordnung nach einem der Ansprüche 10 bis 13, dadurch gekennzeichnet, daß an die Ausgänge (14, 15, 16) der Komparatoren (3, 4, 5) ein Analogdemultiplexer (28) angeschlossen ist.

15. Schaltungsanordnung nach Anspruch 14, dadurch gekennzeichnet, daß an die Ausgänge (29) des Analogdemultiplexers (28) Leuchtdioden (30) angeschlossen sind.

16. Schaltungsanordnung nach einem der Ansprüche 10 bis 15, dadurch gekennzeichnet, daß eingangsseitig ein Spannungsumsetzer (31) vorgesehen ist und der Spanungsumsetzer (31) die Meßspannung in eine der Meßspannung zugeordnete Hilfsspannung umsetzt.

17. Schaltungsanordnung nach Anspruch 16, dadurch gekennzeichnet, daß der Spannungsumsetzer (31) einen Impedanzwandler (32) aufweist.

18. Schaltungsanordnung nach Anspruch 16 oder 17, dadurch gekennzeichnet, daß der Spannungsumsetzer (31) mindestens einen Verstärker (33, 34) aufweist.

19. Schaltungsanordnung nach einem der Ansprüche 16 bis 18, dadurch gekennzeichnet, daß der Spannungsumsetzer (31) einen Schwellwertschalter (35) aufweist und der Schwellwertschalter (35) dann, wenn die Meßspannung die Schaltreferenzspannung erreicht, ein Schaltsignal erzeugt.

20. Schaltungsanordnung nach einem der Ansprüche 16 bis 19, dadurch gekennzeichnet, daß der Spannungsumsetzer (31) einen Differenzverstärker (36)aufweist.

21. Schaltugnsanordnung nach einem der Ansprüche 16 bis 20, dadurch gekennzeichnet, daß der Spannungsumsetzer (31) einen Inverter (37) aufweist.

22. Schaltungsanordnung nach Anspruch 20 und 21, dadurch gekennzeichnet, daß der Differenzverstärker (36) und der Inverter (37) dann, wenn die Meßspannung unterhalb der Schaltreferenzspannung liegt, als Hilfsspannung die Differenz zwischen der Schaltreferenzspannung und der Meßspannung, und dann, wenn die Meßspannung oberhalb der Schaltreferenzspannung liegt, als Hilfsspannung die Differenz zwischen der Meßspannung und der Schaltrefernzspannung erzeugt.

23. Schaltungsanordnung nach einem der Ansprüche 15 bis 22, dadurch gekennzeichnet, daß an die Ausgänge (29) des Analogdemultiplexers (28) jeweils mindestens ein Paar von Leuchtdioden (30), nämlich eine rote Leuchtdiode (30a) und eine grüne Leuchtdiode (30b) angeschlossen sind.

24. Schaltungsanordnung nach Anspruch 19 und 23, dadurch gekennzeichnet, daß mit Hilfe des Schwellwertschalters (35) entweder die roten Leuchtdioden (30a) oder die grünen Leuchtdioden (30b) "vorprogrammiert" sind.

25. Schaltungsanordnung nach einem der Ansprüche 15 bis 24, dadurch gekennzeichnet, daß jeweils ein Paar von roten Leuchtdioden (30a) bzw. ein Paar von grünen Leuchtdioden (30b) eine gemeinsame Anode haben und in einem gemeinsamen Gehäuse (38) der Bauform SOT 23 vorgesehen sind.

Fig.1

Fig. 2

Fig.3

# Fig.4

# Fig.5